# FASCICULE DE BREVET EUROPEEN

(11) **EP 2 212 871 B1**
(45) Date de publication et mention de la délivrance du brevet: **23.02.2011**
(21) Numéro de dépôt: 08846064.7
(22) Date de dépôt: 30.10.2008
(51) Int. Cl.: G08B 21/20, G08B 21/22, H05K 9/00

(54) **DISPOSITIF POUR LE CONTRÔLE DE LA CONNECTION AU SYSTEME DE PROTECTION ANTISTATIQUE**
VORRICHTUNG ZUR KONTROLLE DES ANSCHLUSSES AN EIN ANTISTATISCHES SCHUTZSYSTEM
DEVICE FOR CONTROLLING CONNECTION TO AN ANTISTATIC PROTECTION SYSTEM

(30) Priorité: 02.11.2007 FR 0707734
(43) Date de publication de la demande: 04.08.2010
(73) Titulaire: Ovea-Concept Sarl, 33870 Beaumont sur Leze (FR)
(72) Inventeur: DENEAU, Pascal, Gervais, Michel, F-31140 Pechbonnieu (FR); HETREUX, Véronique, F-31870 Beaumont Sur Leze (FR)
(74) Mandataire: Ravina, Bernard
(86) Numéro de dépôt international: PCT/EP2008/064724
(87) Numéro de publication internationale: WO 2009/056593

(56) Documents cités:
- WO-A-00/70570
- DE-A1- 4 235 379
- US-B1- 6 930 612

## Description

La présente invention concerne un dispositif qui permet de rappeler à un opérateur travaillant notamment dans une unité d'assemblage de composants ou produits électroniques, mais aussi dans tout autre lieu sensible aux décharges d'électricité statique, que le port du bracelet de protection contre ces décharges d'électricité statique est obligatoire et que ledit bracelet doit être connecté dès lors qu'il s'installe à son poste de travail.

En électronique, les composants actifs sont de plus en plus sensibles aux décharges d'électricité statique. Les exigences qualité s'accentuent, les protections deviennent systématiques pour leur manipulation. Dans d'autres activités, la génération d'étincelles liées à une décharge d'électricité statique, peut avoir des conséquences catastrophiques, comme dans le cas des ambiances explosives. Pour prévenir ce type de problèmes, l'environnement, les équipements et le personnel doivent être équipés de dispositifs spécifiques. Les postes de travail sont revêtus de tapis antistatiques connectés à la terre, les machines, les équipements et les outillages sont construits avec des matériaux spéciaux, le personnel s'équipe de vêtements de travail spécifiques, de chaussures ou talonnettes spéciales et/ou d'un bracelet antistatique. Les charges électrostatiques accumulées par l'opérateur sont ainsi évacuées au travers d'un de ces dispositifs, et notamment par l'intermédiaire d'un bracelet relié à la terre. Ce système de protection, qui apporte un niveau de sécurité élevé, ne permet cependant pas à l'opérateur de le prévenir de la non connexion de son bracelet de protection au poste de travail, problème régulièrement observé lors des audits qualité. La formation et la re-sensibilisation des opérateurs n'est pas suffisante pour garantir le port et le branchement systématique de cette protection.

DE 42 35 379 A1 et US-B1-6 930 912 décrivent des dispositifs d'alerte pour le port par un opérateur d'un système antistatique dans un poste de travail.

WO 00/70570 décrit un bracelet de sécurité avec un détecteur de mouvement.

Le but de l'invention est de trouver une solution simple et adaptée pour pallier à l'oubli de connexion du bracelet antistatique. La solution proposée repose sur l'élaboration d'un dispositif d'alerte permettant de prévenir l'opérateur qu'il doit systématiquement connecter son bracelet de protection au poste de travail. Contrairement à d'autres dispositifs connus, il ne s'agit pas ici de surveiller uniquement le bon fonctionnement du système antistatique une fois que celui-ci est porté par l'opérateur, mais de permettre que le système antistatique soit effectivement porté et fonctionne quand un opérateur est à son poste de travail. Selon l'invention, le dispositif d'alerte qui est proposé, est capable de se mettre en activité à l'approche d'un opérateur, et de jouer son rôle de sécurité, que l'opérateur s'équipe ou non du dispositif antistatique.

Un autre objectif de l'invention est d'assurer une discrimination efficace entre l'opérateur à son poste de travail et d'autres éléments présents dans son environnement qui ne doivent pas être détectés. Il s'agit en premier lieu de personnes pouvant circuler à proximité du poste de travail. Une autre source d'erreur provient des systèmes antistatiques eux-mêmes. En effet, certains bracelets et leur cordon de liaison sont susceptibles, lorsqu'ils reposent sur le plan de travail, d'induire des effets électriques qui ne peuvent pas être différenciés de ceux induits pas le corps humain. Il est donc recherché un dispositif permettant une activation fiable et non ambiguë par la présence de l'opérateur.

Ainsi, le dispositif selon l'invention permet de rappeler à un opérateur l'obligation de porter le bracelet de protection ESD (ou tout autre dispositif nécessairement en contact avec la peau) équipant un poste de travail sensible, grâce à l'association d'un détecteur de présence de l'opérateur, d'un moyen de contrôle de connexion de l'opérateur au bracelet (ou de toute pièce destinée à être mise en contact avec la peau) et d'un ensemble d'alertes sonore et lumineuses.

Plus précisément, selon l'invention, le dispositif d'alerte pour le port, par un opérateur à son poste de travail, d'un système antistatique comportant une pièce apte à être mise en contact avec la peau de l'opérateur et un cordon de liaison de ladite pièce au poste de travail, comprend, dans un boîtier doté de moyens de fixation audit poste de travail et relié à la terre,
- un détecteur de présence de l'opérateur, apte à fournir une réponse proportionnelle à la vitesse des mouvements et à la proximité de l'opérateur,
- des moyens de contrôle de la connexion de l'opérateur au système antistatique lié à son poste de travail,
- un jeu d'indicateurs sonore et visuels,
- des moyens d'activation desdits moyens de contrôle de la connexion de l'opérateur au système antistatique, lorsque la réponse proportionnelle fournie par le détecteur de présence dépasse un seuil prédéterminé,
- des moyens de pilotage desdits indicateurs sonore et lumineux par lesdits moyens de contrôle de la connexion, et
- une carte électronique supportant des moyens d'interconnexion et de traitement des signaux.

Selon une caractéristique préférée du dispositif d'alerte objet de l'invention, le détecteur de présence de l'opérateur peut être un capteur pyroélectrique infrarouge radial (PIR) sans lentille de Fresnel. Un capteur pyroélectrique est une cellule sensible aux rayons infrarouges dégagés par la chaleur du corps humain, qui détecte le passage ou la présence d'une personne. Ce capteur est ici utilisé sans lentille de Fresnel pour limiter la sensibilité du capteur à l'environnement immédiat du poste de travail. Ce faisant, pour permettre le traitement des signaux de très faible amplitude émis par une présence humaine malgré l'absence d'amplification par une lentille de Fresnel, il est nécessaire que l'alimentation électrique et la sortie soient filtrées avec soin. Le détecteur de présence comprend donc avantageusement un filtre à deux étages des tensions d'alimentation et de sortie (au niveau de quelques µV), qui assure l'élimination des parasites liés à l'alimentation et à la présence de sources d'ondes électromagnétiques dans l'environnement (par exemple un téléphone portable). L'homme de l'art saura choisir les filtres convenables. On obtient ainsi une portée de détection limitée à l'environnement immédiat du poste de travail, tout en permettant le traitement de signaux de très faible amplitude.

De préférence, le détecteur de présence selon l'invention est placé dans le boîtier au niveau d'un orifice pratiqué dans celui-ci, dont la conformation définit une zone de détection limitée à un cône dont l'angle est compris entre 50° et 70°. L'angle du cône peut être communément de l'ordre de 60°. Une telle conformation peut par exemple être obtenue lorsque le diamètre et l'épaisseur de la paroi en bordure dudit orifice définissent un masque qui délimite la fenêtre de perception du détecteur, l'élément sensible dudit détecteur étant placé dans une positon relative adéquate par rapport à l'orifice du boîtier. L'étroitesse de la plage sensible du détecteur, associée à un orifice calibré du boîtier, permet de distinguer l'opérateur installé à son poste de travail d'une personne proche.

Selon une autre caractéristique préférée du dispositif d'alerte de l'invention, le détecteur de présence de l'opérateur comprend un amplificateur et un comparateur de mouvements. Ces composants connus en eux-mêmes, ne seront pas décrits en détail ici.

Selon encore une autre caractéristique préférée du dispositif d'alerte objet de l'invention, les moyens de contrôle de la connexion comprennent un commutateur reliant ladite pièce, (i) à la terre quand il est en position de repos, et (ii) aux moyens de contrôle de la connexion quand il est activé. Ainsi, le capteur de présence permute d'une position de repos reliant la pièce en contact avec la peau à la terre, vers une position de contrôle. Cette permutation, qui dure moins d'une milliseconde dans le cas d'un opérateur se trouvant correctement connecté, assure une liaison quasi-permanente au système antistatique, conformément aux normes en vigueur.

Selon un mode de réalisation préféré de l'invention, les moyens de contrôle de la connexion comprennent un oscillateur à haute impédance et un détecteur de connexion apte à réagir à une variation d'impédance de valeur prédéterminée. Quand une personne se connecte en mettant la pièce du système antistatique en contact avec sa peau, la variation d'impédance à l'entrée de l'oscillateur auquel la pièce de contact avec la peau se trouve reliée, se traduit par une variation de fréquence de l'oscillateur, dans le sens d'un allongement de la période. Lorsque la période atteint le seuil prédéterminé, la connexion est réputée établie et le détecteur de connexion transmet un signal en conséquence aux unités de pilotage des indicateurs sonore et lumineux.

Selon un mode de réalisation, le seuil est fixé au moment de l'installation du dispositif par exemple à 4 000 Hz, ce qui correspond à une période de 0,25 ms. Selon un autre mode de réalisation, un ajustement est possible après la mise en service pour permettre une adaptation à différents matériels antistatiques pouvant équiper le poste de travail. Dans ce cas, une résistance modulable est ajoutée au détecteur de connexion, autorisant un ajustement du seuil dans une plage allant de 3 500 Hz à 4 500 Hz.

Le circuit d'entrée de l'oscillateur à haute impédance doit utiliser une capacité faible (par exemple d'environ 20 picofarads), du fait que la capacité apportée par un être humain est d'un ordre de grandeur d'une centaine de picofarads seulement. Une autre contraire découle de l'impédance parasite provenant d'une pièce pour le contact avec la peau et de son cordon de liaison, lorsqu'il repose sur le poste de travail. C'est pourquoi, selon l'invention, l'oscillateur, et notamment son étage d'entrée, a été adapté en impédance et en fréquence.

De manière avantageuse, dans le dispositif d'alerte selon l'invention, la fréquence de réception de l'oscillateur se situe dans la plage de 3 kHz à 5 kHz. Cette bande de fréquences particulièrement basse, est celle qui permet de minimiser l'effet capacitif et selfique d'un cordon de liaison laissé en contact avec le tapis de protection contre les décharges électrostatiques (ESD). On obtient ainsi une différenciation fiable entre les effets induits par le corps de l'opérateur et ceux induits par un ensemble cordon - bracelet non porté.

Avec une telle impédance d'entrée, le circuit d'entrée de l'oscillateur doit en outre nécessairement comporter une protection contre les risques de surtension et de décharges électrostatiques apportées par le corps humain au moment de la connexion. Or, les filtres classiques ne peuvent pas être utilisés dans ce cas, car il modifieraient d'une manière considérable l'impédance et la sensibilité de l'entrée, rendant impossible la détection d'un être humain. Cette protection est réalisée en respectant les autres contraintes exposées ci-avant, conformément à l'invention, par un ensemble de diodes Zener, associé à un jeu de résistances en série dont la valeur (exprimée en ohms) est équivalente à un dixième de celle du cordon de liaison de la pièce de contact.

Ainsi, la sensibilité de l'oscillateur est préservée dans toute la bande de fréquence retenue, et le dispositif permet l'utilisation de bracelets ou pièces standards, sans nécessité de remplacement des systèmes déjà utilisés.

Selon un mode de réalisation intéressant du dispositif d'alerte selon l'invention, les moyens de pilotage des indicateurs sonore et lumineux comprennent une unité de pilotage d'un indicateur sonore et une unité de pilotage d'indicateurs lumineux, chaque unité étant reliée d'une part aux moyens de contrôle de la connexion et d'autre part aux moyens de détection de présence.

De préférence, selon l'invention, l'unité de pilotage de l'indicateur sonore est associée à un temporisateur. Par exemple, l'alerte sonore est activée par le temporisateur pour une période d'environ 30 secondes et se manifeste par l'émission d'un "bip" répété toutes les 5 secondes environ, dans le but de réduire la nuisance sonore pour l'entourage, notamment lors du départ de la personne de son poste de travail.

Selon une caractéristique avantageuse du dispositif d'alerte objet de l'invention, l'unité de pilotage des indicateurs lumineux comprend un circuit apte à allumer au moins un indicateur lumineux lorsque la réponse proportionnelle fournie par le détecteur de présence dépasse un seuil prédéterminé, quel que soit l'état du détecteur de connexion.

Ainsi, lorsque le détecteur de présence est déclenché par la présence de l'opérateur, le dispositif d'alerte fonctionne même si le bracelet n'est pas connecté, ce qui garantit que l'opérateur est averti qu'il doit s'équiper.

Le dispositif tel que décrit ci-dessus permet de rappeler à un opérateur travaillant notamment dans une unité d'assemblage de composants ou produits électroniques, mais aussi dans tout autre lieu sensible aux décharges d'électricité statique, que le port du bracelet de protection (ou autre système équivalent) est obligatoire et qu'il doit être connecté au poste de travail. Ce rappel est caractérisé par une alerte sonore et visuelle dés qu'une personne non connectée au système de protection électrostatique est présente au poste. Le dispositif d'alerte permet en outre de contrôler que le système antistatique fonctionne bien pour garantir une totale qualité de la production.

Lorsqu'un opérateur approche de son poste de travail, il entre dans le champ de détection du capteur, lequel capteur active le dispositif objet de la présente invention. Une alerte sonore et un indicateur lumineux informent l'opérateur de la nécessité de se connecter au système de protection électrostatique. Lorsqu'une connexion est établie entre ledit dispositif et l'opérateur par l'intermédiaire de la pièce du système antistatique en contact avec sa peau et de son cordon de liaison, l'alerte sonore s'arrête, l'indicateur lumineux change de couleur et le dispositif commute alors le cordon de liaison vers la connexion de terre. A chaque mouvement significatif de l'opérateur, le dispositif vérifie que la connexion par le bracelet est toujours correctement établie. Pour éviter les perturbations de l'entourage, dans le cas ou l'opérateur ne s'est pas connecté ou dans le cas ou l'opérateur quitte son poste de travail, l'alerte sonore s'arrête au bout de quelques dizaines de secondes, mais l'indicateur lumineux reste en état d'alerte. L'utilisation de composants à faible consommation de courant permet l'utilisation d'une source d'alimentation de faible puissance, notamment une cellule photoélectrique. Le dispositif est conçu de façon symétrique pour permettre un positionnement sur ou sous le poste de travail selon un axe quelconque. De faibles dimensions il s'intègre dans le poste de travail avec un minimum d'encombrement.

Un procédé d'alerte pouvant être mis en oeuvre à l'aide d'un dispositif tel que décrit précédemment et conformément à ce mode de fonctionnement, est également objet de la présente invention.

Ainsi est revendiqué un procédé d'alerte pour le port par un opérateur à son poste de travail d'un système antistatique comportant une pièce devant être mise en contact avec la peau de l'opérateur et un cordon de liaison de ladite pièce au poste de travail, ledit procédé comprenant essentiellement les étapes consistant à :
- a) équiper ledit poste de travail d'un dispositif d'alerte tel que décrit précédemment, comprenant un détecteur de présence, des moyens de contrôle d'une connexion de l'opérateur audit système antistatique et des indicateurs sonores et lumineux,
- b) détecter la présence d'un opérateur à proximité du poste de travail et fournir une réponse proportionnelle à la vitesse des mouvements et à la proximité de l'opérateur,
- c) lorsque la réponse proportionnelle fournie par le détecteur de présence dépasse un seuil prédéterminé, activer les moyens de contrôle de la connexion de l'opérateur au système antistatique lié à son poste de travail, et
- d) piloter lesdits indicateurs sonores et lumineux en fonction des résultats du contrôle de la connexion.

Conformément au procédé d'alerte selon l'invention, de préférence, la présence d'un opérateur est détectée par un capteur pyroélectrique infrarouge radial dans un cône ayant un angle compris entre 50° et 70°, de portée maximum allant de 0,5 m à 1 m. La délimitation de la zone de détection dudit capteur peut être obtenue en plaçant le capteur au voisinage d'un orifice pratiqué dans le boîtier, de manière que les bords limitent le champ de détection du capteur. L'emploi d'un capteur sans lentille de Fresnel permet de limiter la sensibilité à la distance voulue, moyennant les adaptation décrites plus haut.

Selon une caractéristique préférée du procédé ici revendiqué, lors de l'activation des moyens de contrôle de la connexion, le commutateur passe de sa position de repos à sa position de contrôle et permute la liaison de ladite pièce avec la terre pour une liaison de ladite pièce avec les moyens de contrôle de la connexion.

Dans le procédé d'alerte selon l'invention, le contrôle de la connexion comprend avantageusement la réception du signal d'impédance par un oscillateur dont la fréquence (ou la période) varie en fonction de l'impédance apportée par l'opérateur connecté.

De manière avantageuse, dans le procédé d'alerte selon l'invention, la fréquence de réception de l'oscillateur se situe dans la plage de 3 kHz à 5 kHz, de façon à discriminer l'impédance apportée par un opérateur connecté et l'impédance parasite d'une pièce pour le contact avec la peau et de son cordon de liaison, reposant sur le poste de travail, celui-ci étant généralement muni d'un tapis de protection des décharges électrostatiques (tapis de protection ESD).

Egalement de manière avantageuse, dans le procédé d'alerte selon l'invention l'oscillateur (7) est protégé des décharges électrostatiques par un ensemble de diodes Zener, associé à un jeu de résistances en série dont la valeur exprimée en ohms est équivalente à un dixième au plus de celle du cordon de liaison de la pièce.

L'oscillateur est ainsi utilisable avec un dispositif standard de protection ESD mono-conducteur. Le système de détection permet ainsi de détecter sélectivement la présence d'un corps humain connecté à un système antistatique. Il permet en particulier l'utilisation des modèles de bracelet dotés d'un cordon à un seul conducteur, qui sont les plus communs et les moins chers.

Selon une caractéristique particulièrement avantageuse du procédé d'alerte objet de la présente invention, lorsque à l'étape c), la réponse proportionnelle fournie par le détecteur de présence dépasse un seuil prédéterminé, les moyens de pilotage activent au moins un desdits indicateurs sonore ou lumineux pour émettre un signal indiquant que le dispositif est en fonctionnement, quel que soit le résultat du contrôle de la connexion de l'opérateur au système antistatique de son poste de travail. Une alarme est donc déclenchée à l'approche de l'opérateur de son poste de travail, avant même qu'il s'équipe du système antistatique.

De préférence, selon l'invention, un ou plusieurs des indicateurs lumineux destinés à alerter visuellement l'opérateur sont allumés par l'unité de pilotage en fonction des signaux reçus depuis le détecteur de connexion et depuis les moyens de détection de présence. Par exemple, un ensemble de voyants peut être relié à l'unité de pilotage, un voyant rouge s'allumant pour l'oubli de connexion, un voyant jaune s'éteignant à chacun des mouvements détectés, et un voyant vert s'allumant lorsque la connexion est de qualité suffisante (supérieure au seuil de réponse prédéterminé), ce même dispositif permettant aussi un contrôle du bon fonctionnement de l'ensemble du dispositif d'alerte.

Selon un mode de mise en oeuvre préféré de l'invention, l'unité de pilotage sonore est soumise à un temporisateur modifiant le signal émis par l'indicateur sonore en fonction du temps. De la sorte on peut moduler la fréquence et l'intensité de l'émission sonore de sorte que le dispositif reste efficace sans indisposer l'opérateur et ses voisins.

D'autres avantages et caractéristiques de l'invention apparaîtront à la lecture de la description ci-après d'une forme de réalisation donnée à titre d'exemple non limitatif, illustrée par les dessins joints dans lesquels :
La figure 1 représente le schéma de principe du fonctionnement de la carte électronique.
La figure 2 représente le schéma électronique de la carte électronique.
La figure 3 représente une vue éclatée du dispositif.

Le dispositif d'alerte ici présenté comprend :
- le boîtier 14 et son couvercle 15, pour fixer ledit dispositif dans l'environnement d'un poste de travail,
- le capteur 1 de type PIR (capteur pyroélectrique infrarouge radial) pour détecter la présence et les mouvements de l'opérateur, dans un champ restreint à l'environnement immédiat du poste de travail,
- l'émetteur sonore 9, par exemple un haut-parleur, pour alerter l'opérateur de l'obligation de se connecter rigoureusement,
- les indicateur lumineux 10, 11 et 12, pour une alerte visuelle et la vérification du fonctionnement du dispositif,
- le connecteur 13 pour l'alimentation électrique du dispositif, reliant le dispositif à la terre, et connectant le bracelet antistatique 6 de l'opérateur,
- la carte électronique 16, support des interconnexions et des organes de traitement des signaux des éléments listés ci-dessus.

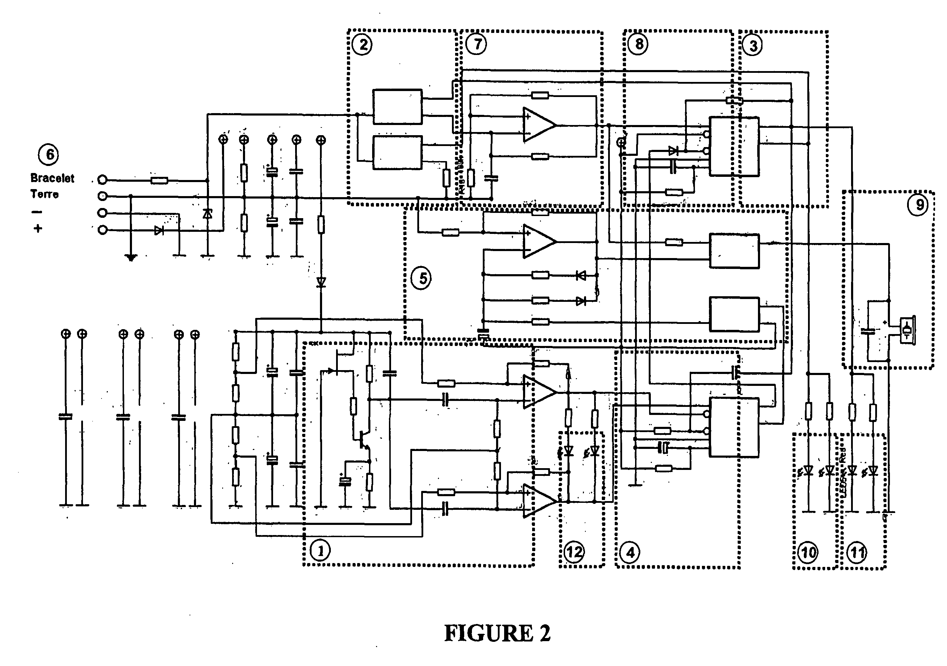

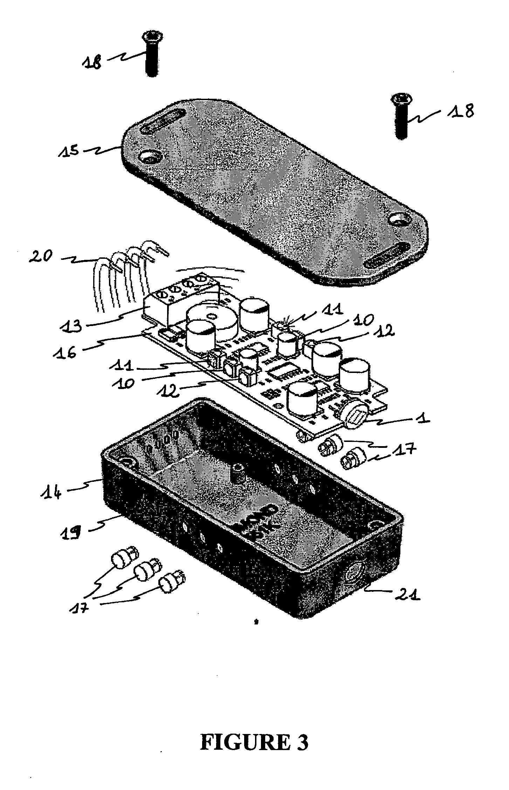

La carte électronique 16 est conçue selon le schéma électronique représenté par la figure 2. Cette carte est intégrée dans le boîtier 14 fermé par le couvercle 15 illustré par la figure 3, dont les dimensions approximatives sont ici 80mm x 40mm x 20mm. Une construction symétrique et de faible encombrement permet un placement selon un axe quelconque dans la périphérie de l'opérateur, par exemple par fixation au-dessus ou au-dessous du poste de travail. Les alertes sonores et visuelles peuvent être entendues et/ou observées quel que soit l'emplacement du dispositif. L'alerte sonore est transmise à travers les trous 19 ménagés de parts et d'autres du boîtier. L'alerte visuelle est transmise par l'intermédiaire de capuchons de diodes électroluminescentes 17 disposés de parts et d'autres du boîtier. L'emploi de composants à très faible consommation de courant permet l'alimentation du dispositif par une cellule photoélectrique, ou tout autre générateur de très faible puissance.

La carte électronique 16 est placée au fond du boîtier 14, face composants vers le haut. Le boîtier 14 est équipé de six capuchons pour diodes électroluminescente 17, pour améliorer la diffusion de la lumière des voyants lumineux 10, 11, 12. Après branchement des quatre fils 20 par l'intermédiaire du connecteur 13 (soit deux fils pour l'alimentation, un fil pour la terre, un fil pour le bracelet), le couvercle15 du boîtier fermera le dispositif à l'aide de deux vis 18. Le dispositif d'alerte pourra être fixé dans l'environnement du poste de travail par deux autres vis traversant les lumières du couvercle 15 du boîtier.

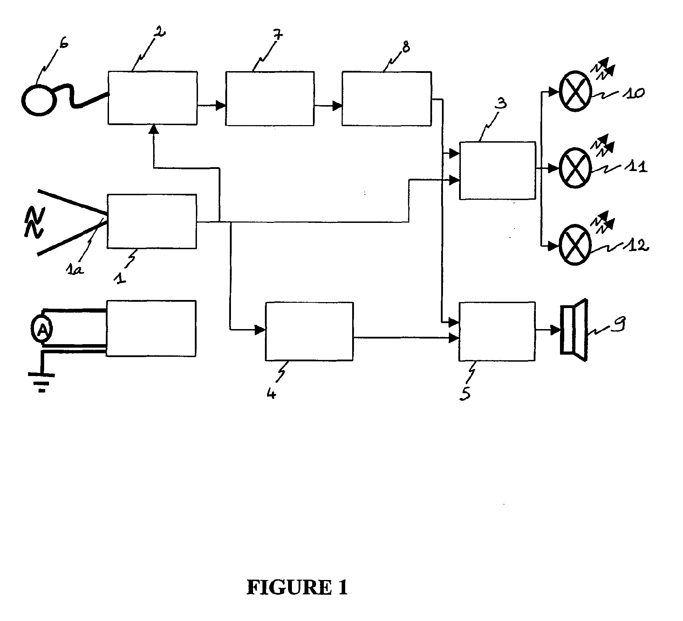

Le dispositif fonctionne suivant le schéma de principe illustré par la figure 1. Lorsqu'une personne entre dans le champ du capteur de présence 1, une variation de tension est générée sur sa sortie, en fonction de la vitesse du déplacement et de la proximité de la personne. Cette variation de tension est amplifiée de telle sorte que le comparateur soit déclenché pour des mouvements significatifs. Ce comparateur, étage final du détecteur de mouvement 1, active le commutateur 2 pour le contrôle de la connexion de la personne au bracelet de protection antistatique.

La sortie du détecteur de présence 1 est aussi reliée au dispositif de pilotage de l'indicateur lumineux 3. Un voyant rouge 10 s'allume tant que la connexion au bracelet n'est pas réalisée. La sortie du détecteur de présence 1 déclenche également le temporisateur 4, lequel contrôle le pilotage de l'alerte sonore 5.

Sous l'effet du détecteur de présence 1, le commutateur 2 bascule l'entrée à laquelle le bracelet 6 doit être connecté, d'une position de repos commutée à la terre, vers une position de contrôle. Le bracelet 6 se trouve relié alors à l'oscillateur à haute impédance d'entrée 7. La variation d'impédance liée à la présence ou non d'une personne connectée au bracelet se traduit par une variation de fréquence de l'oscillateur 7, notamment par un allongement de la période. Cette disposition permet l'utilisation d'un bracelet standard simple conducteur, ou tout autre dispositif nécessairement en contact avec la peau.

Cette période est analysée par le détecteur de connexion 8. Lorsque cette période est suffisamment longue, le détecteur 8 devient inactif. Le voyant rouge 10 s'éteint, un voyant vert 11 s'allume indiquant une connexion correcte de la personne. Le commutateur 2 bascule l'entrée du bracelet 6 vers la terre.

Dans le cas où la variation d'impédance est insuffisante (c'est-à-dire qu'elle n'atteint pas le niveau prédéterminé correspondant à la présence d'une personne), le détecteur de connexion 8 reste inactif, et le voyant rouge 10 reste allumé. Le pilotage de l'alerte sonore 5 est activée jusqu'à ce que le temporisateur 4 arrive à la fin d'une période d'environ 30 secondes. Le dispositif sonore 9 émet un "bip" répété toutes les 5 secondes environ pendant cette période. A l'issue de la période d'activation du temporisateur 4, le dispositif se met en veille jusqu'au prochain mouvement, son voyant rouge 10 reste allumé. Un voyant jaune 12 indique que le système est en fonctionnement. Son extinction fugitive indique qu'un nouveau mouvement de la personne a été détecté.

## Revendications

1. Dispositif d'alerte pour le port par un opérateur à son poste de travail, d'un système antistatique comportant une pièce (6) apte à être mise en contact avec la peau de l'opérateur et un cordon de liaison de ladite pièce au poste de travail, ledit dispositif comprenant, dans un boîtier (14, 15) doté de moyens de fixation audit poste de travail et relié à la terre,
- un détecteur de présence (1) de l'opérateur, apte à fournir une réponse proportionnelle à la vitesse des mouvements et à la proximité de l'opérateur,
- des moyens de contrôle (2, 7, 8) de la connexion de l'opérateur au système antistatique lié à son poste de travail,
- un jeu d'indicateurs sonore (9) et visuels (10, 11, 12),
- des moyens d'activation desdits moyens de contrôle de la connexion de l'opérateur au système antistatique, lorsque la réponse proportionnelle fournie par le détecteur de présence (1) dépasse un seuil prédéterminé,
- des moyens de pilotage (3, 5) desdits indicateurs sonore et lumineux par lesdits moyens de contrôle de la connexion, et
- une carte électronique (16) supportant des moyens d'interconnexion (20) et de traitement des signaux.

2. Dispositif d'alerte selon la revendication 1, **caractérisé en ce que** le détecteur de présence (1) de l'opérateur est un capteur pyroélectrique infrarouge radial dépourvu de lentille de Fresnel.

3. Dispositif d'alerte selon la revendication 1 ou 2, **caractérisé en ce que** le détecteur de présence (1) de l'opérateur est placé dans le boîtier au niveau d'un orifice pratiqué dans celui-ci, dont la conformation définit une zone de détection limitée à un cône dont l'angle est compris entre 50° et 70°.

4. Dispositif d'alerte selon l'une des revendications précédentes, **caractérisé en ce que** le détecteur de présence (1) de l'opérateur comprend un amplificateur et un comparateur de mouvements.

5. Dispositif d'alerte selon l'une des revendications précédentes, **caractérisé en ce que** les moyens de contrôle de la connexion comprennent un commutateur (2) reliant ladite pièce (6), i) à la terre quand il est en position de repos, et ii) aux moyens de contrôle de la connexion quand il est activé.

6. Dispositif d'alerte selon l'une des revendications précédentes, **caractérisé en ce que** les moyens de contrôle de la connexion comprennent un oscillateur (7) à haute impédance et un détecteur de connexion (8) apte à réagir à une variation de période, conséquence de la variation d'impédance à l'entrée de l'oscillateur (7).

7. Dispositif d'alerte selon l'une des revendications précédentes, **caractérisé en ce que** l'oscillateur (7) à haute impédance a une fréquence de réception se situant dans la plage de 3 kHz à 5 kHz, de façon à discriminer l'impédance apportée par un opérateur connecté et l'impédance parasite d'une pièce (6) pour le contact avec la peau et de son cordon de liaison, reposant sur le poste de travail.

8. Dispositif d'alerte selon la revendication précédente, **caractérisé en ce que** l'oscillateur (7) à haute impédance comprend un ensemble de diodes Zener, associé à un jeu de résistances en série dont la valeur exprimée en ohms est équivalente à un dixième de celle du cordon de liaison de la pièce.

9. Dispositif d'alerte selon l'une des revendications précédentes, **caractérisé en ce que** les moyens de pilotage des indicateurs sonore et lumineux comprennent une unité de pilotage d'un indicateur sonore (5) et une unité de pilotage d'indicateurs lumineux (3), chaque unité étant reliée d'une part aux moyens de contrôle de la connexion et d'autre part aux moyens le détection de présence.

10. Dispositif d'alerte selon la revendication précédente, **caractérisé en ce que** l'unité de pilotage (5) de l'indicateur sonore est associée à un temporisateur (4) apte à modifier le signal émis par l'indicateur sonore (9) en fonction du temps, et l'unité de pilotage des indicateurs lumineux (3) comprend un circuit apte à allumer au moins un indicateur lorsque la réponse proportionnelle fournie par le détecteur de présence dépasse un seuil prédéterminé, quel que soit l'état du détecteur de connexion.

11. Procédé d'alerte pour le port par un opérateur à son poste de travail d'un système antistatique comportant une pièce (6) devant être mise en contact avec la peau de l'opérateur et un cordon de liaison de ladite pièce au poste de travail, comprenant les étapes consistant à :
- a) équiper ledit poste de travail d'un dispositif d'alerte selon l'une des revendications 1 à 11, comprenant un détecteur de présence (1), des moyens de contrôle de la connexion de l'opérateur au système antistatique et des indicateurs sonores et lumineux (9, 10, 11, 12),
- b) détecter la présence d'un opérateur à proximité du poste de travail et fournir une réponse proportionnelle à la vitesse des mouvements et à la proximité de l'opérateur,
- c) lorsque la réponse proportionnelle fournie par le détecteur de présence dépasse un seuil prédéterminé, activer les moyens de contrôle de la connexion de l'opérateur au système antistatique lié à son poste de travail, et
- d) piloter lesdits indicateurs sonores et lumineux en fonction des résultats du contrôle de la connexion.

12. Procédé d'alerte selon la revendication précédente, **caractérisé en ce que** la présence d'un opérateur est détectée par un capteur pyroélectrique infrarouge radial dans un cône ayant un angle compris entre 50° et 70°, de portée maximum allant de 0,5 à 1 m.

13. Procédé d'alerte selon l'une des revendications 11 ou 12, **caractérisé en ce que**, lors de l'activation des moyens de contrôle de la connexion, le commutateur (2) passe de sa position de repos à sa position de contrôle et permute la liaison de ladite pièce avec la terre pour une liaison de ladite pièce avec les moyens de contrôle de la connexion.

14. Procédé d'alerte selon l'une des revendications 11 à 13, **caractérisé en ce que** le contrôle de la connexion comprend la réception du signal d'impédance par un oscillateur (7), dont la fréquence varie en fonction de l'impédance apportée par l'opérateur connecté, lesdites fréquences se situant dans la plage de 3 kHz à 5 kHz, de façon à discriminer l'impédance apportée par un opérateur connecté de l'impédance d'une pièce (6) pour le contact avec la peau et de son cordon de liaison, reposant sur le poste de travail.

15. Procédé d'alerte selon l'une des revendications 11 à 14, **caractérisé en ce que**, lorsque à l'étape c), la réponse proportionnelle fournie par le détecteur de présence dépasse un seuil prédéterminé, les moyens de pilotage activent au moins un desdits indicateurs sonore ou lumineux pour émettre un signal indiquant que le dispositif est en fonctionnement, quel que soit le résultat du contrôle de la connexion de l'opérateur au système antistatique de son poste de travail.

## Claims

1. Alarm device concerning the wearing by an operator at his workstation of an antistatic device including a part (6) fit to be in contact with the operator's skin and a cord connecting said part to the workstation, with said device to include a unit (14, 15) fitted with fasteners to said workstation and connected to the earth,
- an operator presence sensor (1), able to provide a response in proportion to the speed of the operator's moves, and to how close he is,
- means (27, 8) for checking of the connection between the operator and the antistatic device linked to his workstation,
- a set of sound (9) and visual (10, 11, 12) indicators,
- means of activating said means for checking of the connection of the operator to the antistatic device, when the proportional response given by the presence sensor (1) exceeds a predetermined threshold,
- means of controlling (3, 5) said sound and visual indicators through said means for checking of the connection, and
- a printed circuit board (16) supporting means of interconnection (20) and signal processing.

2. Alarm device according to claim 1, **characterised in that** the operator presence sensor (1) is an infrared radial pyroelectric sensor without Fresnel lens.

3. Alarm device according to claim 1 or 2, **characterised in that** the operator presence sensor (1) is placed in the unit, at the location of an orifice in this unit, whose conformation defines a detection zone limited to a cone with an angle between 50° and 70°.

4. Alarm device according to one of the claims above, **characterised in that** the operator presence sensor (1) includes a motion amplifier and comparator.

5. Alarm device according to one of the claims above, **characterised in that** means for checking of the connection include a switch (2) connecting said part (6), i) to the earth when in idle position, and ii) to the means for checking of the connection when activated.

6. Alarm device according to one of the claims above, **characterised in that** the means for checking of the connection include a high-impedance oscillator (7) and a connection sensor (8) capable of reacting to a period variation caused by the impedance variation at the oscillator input (7).

7. Alarm device according to one of the claims above, **characterised in that** the high-impedance oscillator (7) has a receiving frequency in the 3 kHz to 5 kHz range, to distinguish between the impedance generated by a connected operator and the unwanted impedance of a part (6) for contact with the skin and of its connection cord, located on the workstation.

8. Alarm device according to the claim above, **characterised in that** the high-impedance oscillator (7) includes a set of Zener diodes, associated with a set of series resistors whose value expressed in ohms is equivalent to one tenth of that of the part connection cord.

9. Alarm device according to one of the claims above, **characterised in that** the means for controlling the sound and visual indicators include a sound indicator control unit (5) and a visual indicator control unit (3), each unit being connected, on the one hand to the means for checking of the connection, and on the other hand to the presence detection means.

10. Alarm device according to the claim above, **characterised in that** the sound indicator control unit (5) is associated with a temporiser (4) capable of modifying the signal transmitted by the sound indicator (9) according to time, and **in that** the visual indicator control unit (3) includes a circuit capable of turning on at least one indicator when the proportional response given by the presence sensor exceeds a predetermined threshold, irrespective of the state of the connection sensor.

11. Alarm method concerning the wearing by an operator at his workstation of an antistatic device including a part (6) to be in contact with the operator's skin and a cord connecting said part to the workstation, including the steps consisting in:
- a) fitting said workstation with an alarm device according to the one of claims 1 to 11, including a presence sensor (1), means for checking of the connection between the operator and the antistatic device, and sound and visual indicators (9, 10, 11, 12),
- b) detecting the presence of an operator near the workstation and provide a response in proportion to the speed of the operator's moves, and to how close he is,
- c) when the proportional response given by the presence sensor exceeds a predetermined threshold, activating the means for checking of the connection between the operator and the antistatic device linked to his workstation, and
- d) controlling said visual and sound indicators according to the connection verification results.

12. Alarm method according to the claim above, **characterised in that** the presence of an operator is detected by an infrared radial pyroelectric sensor within a cone with an angle between 50° and 70°, with a maximum range from 0.5 to 1 m.

13. Alarm method according to the one of claims 11 or 12, **characterised in that**, when the means for checking of the connection are activated, the switch (2) moves from its idle position to its checking position, and switches from connection of said part to the earth to connection of said part to the means for checking of the connection.

14. Alarm method according to the one of claims 11 to 13, **characterised in that** the checking of the connection includes reception of the impedance signal by an oscillator (7), whose frequency varies according to the impedance generated by the connected operator, said frequencies being in the 3 kHz to 5 kHz range, to distinguish between the impedance generated by a connected operator and the impedance of a part (6) for contact with the skin and of its connection cord, located on the workstation.

15. Alarm method according to the one of claims 11 to 14, **characterised in that**, during step c), when the proportional response given by the presence sensor exceeds a predetermined threshold, the control means activate at least one of said sound or visual indicators to transmit a signal indicating that the device is in operation, irrespective of the result of the verification of the connection between the operator and the antistatic device on his workstation.

## Patentansprüche

1. Alarmvorrichtung, die dazu bestimmt ist, dass ein Bediener an seinem Arbeitsplatz ein Antistatiksystem trägt, welches ein Bauteil (6) aufweist, das dazu geeignet ist, mit der Haut des Bedieners in Kontakt gebracht zu werden, sowie eine Schnur zur Verbindung des Bauteils mit dem Arbeitsplatz, wobei die Vorrichtung in einem Gehäuse (14, 15), das mit Mitteln zur Befestigung am Arbeitsplatz versehen ist und geerdet ist, Folgendes umfasst
- einen Detektor (1) für die Anwesenheit des Bedieners, der dazu befähigt ist, eine Antwort zu liefern, welche proportional zur Geschwindigkeit der Bewegungen und zur Nähe des Bedieners ist,
- Mittel zur Überprüfung (2, 7, 8) der Verbindung des Bedieners mit dem Antistatiksystem, welches mit seinem Arbeitsplatz verbunden ist,
- einen Satz akustischer (9) und visueller (10, 11, 12) Anzeiger,
- Mittel zum Aktivieren der Mittel zur Überprüfung der Verbindung des Bedieners mit dem Antistatiksystem, wenn die proportionale Antwort, die vom Anwesenheitsdetektor (1) geliefert wird, einen zuvor festgelegten Schwellenwert überschreitet,
- Mittel zur Steuerung (3, 5) der akustischen und leuchtenden Anzeiger durch die Mittel zur Überprüfung der Verbindung, und
- eine Elektronikkarte (16), auf der sich Mittel zur Quervernetzung (20) und zur Signalverarbeitung befinden.

2. Alarmvorrichtung nach Anspruch 1, **dadurch gekennzeichnet, dass** es sich bei dem Detektor für die Anwesenheit (1) des Bedieners um einen radialen pyroelektrischen Infrarotsensor ohne Fresnel-Linse handelt.

3. Alarmvorrichtung nach Anspruch 1 oder 2, **dadurch gekennzeichnet, dass** der Detektor für die Anwesenheit (1) des Bedieners innerhalb des Gehäuses an einer Öffnung angeordnet ist, die in letzterem geschaffen wurde und durch deren Gestalt ein Detektionsbereich festgelegt wird, welcher auf einen Kegel mit einem Winkel im Bereich von 50° bis 70° beschränkt ist.

4. Alarmvorrichtung nach einem der vorhergehenden Ansprüche, **dadurch gekennzeichnet, dass** der Detektor für die Anwesenheit (1) des Bedieners einen Verstärker und ein Mittel zum Vergleichen von Bewegungen umfasst.

5. Alarmvorrichtung nach einem der vorhergehenden Ansprüche, **dadurch gekennzeichnet, dass** die Mittel zur Überprüfung der Verbindung einen Umschalter (2) umfassen, der das Bauteil (6) i) erdet, wenn er sich in Ruhestellung befindet, und ii) mit den Mitteln zur Überprüfung der Verbindung verbindet, wenn er aktiviert ist.

6. Alarmvorrichtung nach einem der vorhergehenden Ansprüche, **dadurch gekennzeichnet, dass** die Mittel zur Überprüfung der Verbindung einen Oszillator (7) mit hoher Impedanz umfassen sowie einen Verbindungsdetektor (8), der dazu befähigt ist, auf eine Periodenänderung zu reagieren, welche infolge der Impedanzänderung am Eingang des Oszillators (7) auftritt.

7. Alarmvorrichtung nach einem der vorhergehenden Ansprüche, **dadurch gekennzeichnet, dass** der Oszillator (7) mit hoher Impedanz eine Empfangsfrequenz hat, die im Wertebereich von 3 kHz bis 5 kHz liegt, sodass zwischen der Impedanz, die ein verbundener Bediener bewirkt, und der Störimpedanz eines Bauteils (6) für den Kontakt mit der Haut und dessen Verbindungsschnur, welche auf dem Arbeitsplatz ruhen, unterschieden wird.

8. Alarmvorrichtung nach dem vorhergehenden Anspruch, **dadurch gekennzeichnet, dass** der Oszillator (7) mit hoher Impedanz eine Gesamtheit von Zenerdioden umfasst, welcher ein Satz von Widerständen in Reihenschaltung beigeordnet ist, dessen in Ohm ausgedrückter Wert einem Zehntel desjenigen der Verbindungsschnur des Bauteils entspricht.

9. Alarmvorrichtung nach einem der vorhergehenden Ansprüche, **dadurch gekennzeichnet, dass** die Mittel zur Steuerung der akustischen und leuchtenden Anzeiger eine Einheit zur Steuerung eines akustischer Anzeigers (5) und eine Einheit zur Steuerung von leuchtenden Anzeigern (3) umfasst, wobei jede Einheit einerseits mit den Mitteln zur Überprüfung der Verbindung und andererseits mit den Mitteln zur Detektion der Anwesenheit verbunden ist.

10. Alarmvorrichtung nach dem vorhergehenden Anspruch, **dadurch gekennzeichnet, dass** der Einheit zur Steuerung (5) des akustischen Anzeigers ein Zeitgeber (4) beigeordnet ist, der dazu befähigt ist, das Signal, welches vom akustischen Anzeiger (9) ausgesendet wird, in Abhängigkeit von der Zeit zu verändern, und die Einheit zur Steuerung der leuchtenden Anzeiger (3) einen Schaltkreis umfasst, der dazu befähigt ist, mindestens einen Anzeiger anzuschalten, wenn die proportionale Antwort, welche vom Anwesenheitsdetektor geliefert wird, einen zuvor festgelegten Schwellenwert überschreitet, und zwar unabhängig vom Zustand des Verbindungsdetektors.

11. Alarmverfahren, das dazu bestimmt ist, dass ein Bediener an seinem Arbeitsplatz ein Antistatiksystem trägt, welches ein Bauteil (6), das mit der Haut des Bedieners in Kontakt gebracht werden muss, und eine Schnur zur Verbindung des Bauteils mit dem Arbeitsplatz aufweist, umfassend die Schritte, welche darin bestehen:
- a) den Arbeitsplatz mit einer Alarmvorrichtung nach einem der Ansprüche 1 bis 11 auszustatten, wobei diese einen Anwesenheitsdetektor (1), Mittel zur Überprüfung der Verbindung des Bedieners mit dem Antistatiksystem sowie akustische und leuchtende Anzeiger (9, 10, 11, 12) umfasst.
- b) die Anwesenheit eines Bedieners in der Nähe des Arbeitsplatzes zu detektieren und eine Antwort zu liefern, die proportional zur Geschwindigkeit der Bewegungen und zur Nähe des Bedieners ist,
- c) wenn die proportionale Antwort, die vom Anwesenheitsdetektor geliefert wird, einen zuvor festgelegten Schwellenwert überschreitet, die Mittel zur Überprüfung der Verbindung des Bedieners mit dem Antistatiksystem, welches mit seinem Arbeitsplatz verbunden ist, zu aktivieren, und
- d) die akustischen und leuchtenden Anzeiger in Abhängigkeit von den Ergebnissen der Überprüfung der Verbindung zu steuern.

12. Alarmverfahren nach dem vorhergehenden Anspruch, **dadurch gekennzeichnet, dass** die Anwesenheit eines Bedieners in einem Kegel mit einem Winkel im Bereich von 50° bis 70° durch einen radialen pyroelektrischen Infrarotsensor mit einer maximalen Reichweite von 0,5 bis 1 m detektiert wird.

13. Alarmverfahren nach einem der Ansprüche 11 oder 12, **dadurch gekennzeichnet, dass** der Umschalter (2), bei der Aktivierung der Mittel zur Überprüfung der Verbindung, von seiner Ruhestellung in seine Prüfstellung übergeht und die Erdung des Bauteils durch eine Verbindung des Bauteils mit den Mitteln zur Überprüfung der Verbindung ersetzt.

14. Alarmverfahren nach einem der Ansprüche 11 bis 13, **dadurch gekennzeichnet, dass** die Überprüfung der Verbindung den Empfang des Impedanzsignals durch einen Oszillator (7) umfasst, dessen Frequenz sich in Abhängigkeit von der Impedanz, welche durch den verbundenen Bediener bewirkt wird, ändert, wobei diese Frequenzen im Wertebereich von 3 kHz bis 5 kHz liegen, sodass die Impedanz, die ein verbundener Bediener bewirkt, von der Impedanz eines Bauteils (6) für den Kontakt mit der Haut und dessen Verbindungsschnur, welche auf dem Arbeitsplatz ruhen, unterschieden wird.

15. Alarmverfahren nach einem der Ansprüche 11 bis 14, **dadurch gekennzeichnet, dass** die Steuerungsmittel, wenn in Schritt c) die proportionale Antwort, welche vom Anwesenheitsdetektor geliefert wird, einen zuvor festgelegten Schwellenwert überschreitet, mindestens einen der akustischen oder leuchtenden Anzeiger aktivieren, um ein Signal auszusenden, das anzeigt, dass die Vorrichtung in Betrieb ist, und zwar unabhängig vom Ergebnis der Überprüfung der Verbindung des Bedieners mit dem Antistatiksystem seines Arbeitsplatzes.
